# EUROPEAN PATENT APPLICATION

(11) **EP 1 724 087 A1**
(43) Date of publication of application: **22.11.2006**
(21) Application number: 06252342.8
(22) Date of filing: 03.05.2006
(51) Int. Cl.: B29C 45/14

(54) **Method for packaging flash memory cards**

(30) Priority: 19.05.2005 CN 200510070839
(71) Applicant: Liu, Chin-Tong, Noupu South Road Hsinchu (TW)
(72) Inventor: Liu, Chin-Tong, Noupu South Road Hsinchu (TW)
(74) Representative: Gee, Steven William

(57) **Abstract**

A method for packaging flash memory cards is provided, including the steps of forming a shell base (4), placing a circuit substrate (5) inside the shell base (4) with electric contact parts (51) exposed, and using insert molding to form a monolithic shell to enclose the circuit substrate (5). The electric contacts parts (51) of the circuit substrate remain exposed. The method provides a stronger structure for memory cards, and better water-proofing against humidity leakage.

## Description

### FIELD OF THE INVENTION

The present invention generally relates to mini flash memory cards, and more specifically to a packaging method applicable to various types of mini flash memory cards.

### BACKGROUND OF THE INVENTION

The current types of the flash memory cards include compact flash (CF) card, smart media card (SMC), multimedia card (MMC), secure digital (SD) card, and memory stick (MS) card. The xD-Picture card, being a new design, is a high speed read/write flash storage media that is low in power consumption and the smallest in size. The conventional packaging methods for this type of structure usually employ gluing for fixation.

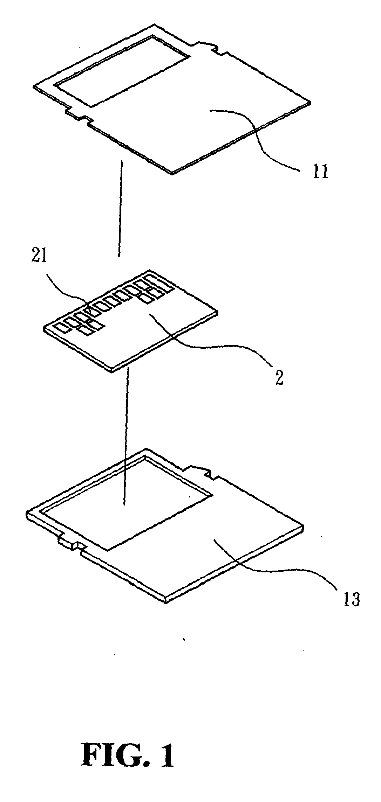

FIG. 1 shows an exploded view of the structure of a conventional mini SD, including a cover housing shell 11, a circuit substrate 2, and a bottom housing shell 13. Cover housing shell 11 and bottom housing shell 13 are manufactured by injection molding to form the required shape. Circuit substrate 2 includes the already packaged chips and related electric connections. During assembly, circuit substrate 2 is placed in bottom housing shell 13, and cover housing shell 11 is placed on top of bottom housing shell 13 to cover circuit substrate 2. A supersonic thermal pressing method is used to glue cover housing shell 11 and bottom housing shell 13 together to seal in circuit substrate 2, with only the electric contact parts 21 on one end of circuit substrate 2 exposed. This type of structure has the drawback of a weak structure because cover housing shell 11, circuit substrate 2 and bottom housing shell 13 are not seamlessly fixed together. The potential gap between them will weaken the structural strength. In addition, cover housing shell 11 is easily separated from bottom housing shell 13 after repetitive uses, and it is easy for water/humidity to leak in to cause damage to the circuit. All these drawbacks shorten the lifespan of the flash memory cards. It is imperative to develop a more effective packaging method to improve the conventional techniques.

### SUMMARY OF THE INVENTION

The present invention has been made to overcome the aforementioned drawback of conventional packaging methods. The primary object of the present invention is to provide a packaging method that is robust and water-proof. The method of the present invention includes the use of insert molding to bury a circuit substrate inside a protective shell so that the protective shell tightly houses the circuit substrate inside. The method provides a structure that is strong and gap-free so that humidity leakage is prevented.

Another object of the present invention is to provide a packaging method that is applicable to a variety of flash memory card types, including major categories, such as, compact flash (CF) card, smart media card (SMC), multimedia card (MMC), secure digital (SD) card, and memory stick (MS) card, and the new xD-Picture card, a high speed read/write flash storage media that is low in power consumption and the smallest in size.

To achieve the above objects, the present invention includes a method including the steps of forming a shell base, placing an electrically connected circuit substrate inside the shell base, using insert molding to form a shell enclosing the circuit substrate with only the electric contact parts of the circuit substrate exposed.

In comparison with the conventional packaging methods, the present invention provides a flash memory cards packaging method that provides better protection against water leakage and stress on the structure caused by repetitive uses.

The foregoing and other objects, features, aspects and advantages of the present invention will become better understood from a careful reading of a detailed description provided herein below with appropriate reference to the accompanying drawings.

### BRIEF DESCRIPTION OF THE DRAWINGS

The present invention can be understood in more detail by reading the subsequent detailed description in conjunction with the examples and references made to the accompanying drawings, wherein:
FIG. 1 shows an exploded view of the structure of a conventional mini SD memory card;
FIG. 2 shows a flowchart of the present invention;
FIG. 3 shows a three-dimensional view of the shell base and the circuit substrate of an mini SD memory card when applying the present invention; and
FIG. 4 shows a three-dimensional view of the final mini SD memory card manufactured by the method of the present invention.

### DETAILED DESCRIPTION OF THE PREFERRED EMBODIMENTS

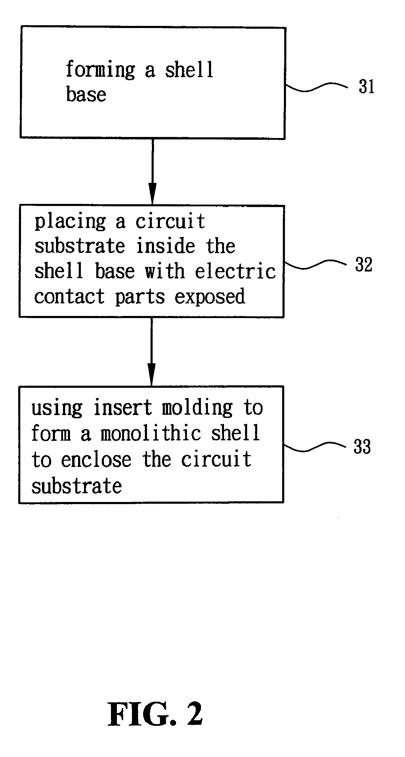

FIG. 2 shows a flowchart of the flash memory card packaging method of the present invention. As shown in FIG. 2, the present invention includes the following steps. Step 31 is to manufacture a shell base. Step 32 is to place a circuit substrate inside the shell base with the electric contact parts on the circuit substrate surface uncovered. Step 33 is to place the shell base inside a mold and use insert molding to flow the molding material over the top and the circumference of the circuit substrate and form a monolithic shell with the shell base so that the monolithic shell covers the top surface, bottom surface and the circumference of the circuit substrate with only the electric contact parts uncovered, i.e., exposed.

The packaging method is applicable to a variety of flash memory card types, including major categories, such as, compact flash (CF) card, smart media card (SMC), multimedia card (MMC), secure digital (SD) card, and memory stick (MS) card, and the new xD-Picture card, a high speed read/write flash storage media that is low in power consumption and the smallest in size.

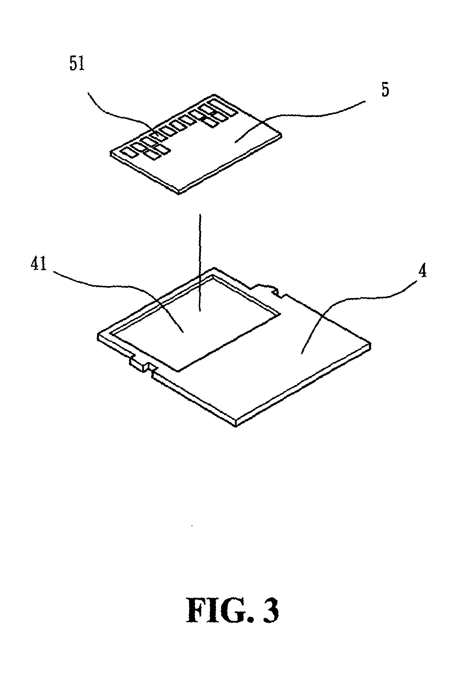

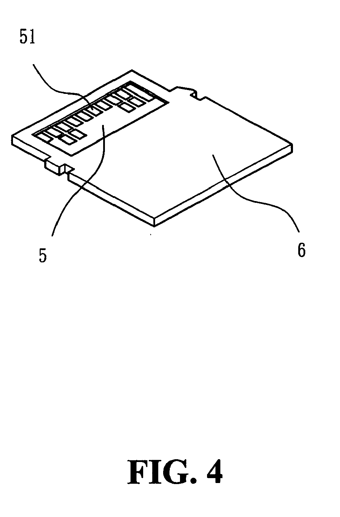

For better clarity, the following embodiment uses a mini SD card as an example for explanation. As shown in FIG. 3, a shell base 4 is manufactured by injection molding to have the shape that meets the standard specification, while having a thinner thickness. The top surface of shell base 4 includes a concave space 41 with a shape matching the shape of a circuit substrate 5 so that circuit substrate 5 fits inside concave space 41. Circuit substrate 5 is a printed circuit board (PCB) that is already electrically connected. The top of circuit substrate 5 includes a plurality of electric contact parts 51, commonly known as gold fingers, for providing electric contact with the device that the flash memory card plugs into. As shown in FIG. 4, when shell base 4 with circuit substrate 5 is placed inside a mold, the aforementioned step 32 is performed to flow the molding material over the top and the circumference of circuit substrate 5 and form a monolithic shell 6 with shell base 4. Monolithic shell 6 encloses circuit substrate 5, and the thickness of monolithic shell 6 meets the specifications of standard memory cards.

Shell base 4 and monolithic shell 6 are both made of material containing acrylonitrile-butadiene-styrene copolymer (ABS) or polycarbonate (PC). Shell base 4 is infused with the material used in insert molding to form monolithic shell 6 so that the final structure is sufficiently strong to avoid disintegration. As no gap exists in monolithic shell 6 and circuit substrate 5, the water/humidity leakage is prevented, and the lifespan of the packaged flash memory card is improved.

Although the embodiment shows that shell base 4 has the shape matching a mini SD card, and concave space 41 has the shape matching circuit substrate 5, the packaging method of the present invention is not limited to this type of memory cards. When the method of the present invention is applied to other types of memory cards, the shape of shell base 4 and the shape of concave space 41 can be changed to match the type of the memory cards.

In summary, present invention uses insert molding to form a monolithic shell with the original shell base so that the circuit substrate is tightly sealed inside the final monolithic structure. The final monolithic structure of the flash memory card is stronger, provides better water-proofing against humidity leakage.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A method for packaging flash memory cards, comprising the steps of:
forming a shell base;
placing a circuit substrate inside said shell base, with a plurality of electric contact parts on said circuit substrate surface uncovered;
placing said shell base inside a mold and using insert molding to form a monolithic shell with said shell base so that the monolithic shell encloses the top surface, bottom surface and the circumference of said circuit substrate with only said electric contact parts exposed.

2. The method as claimed in claim 1, wherein said insert molding step is to flow a molding material over the top and the circumference of said circuit substrate to infuse with said shell base to form said monolithic shell enclosing said circuit substrate.

3. The method as claimed in claim 1, wherein the top surface of said shell base comprises a concave space for housing said circuit substrate.

4. The method as claimed in claim 1, wherein said circuit substrate is a printed circuit board (PCB) with complete electric connections.

5. The method as claimed in claim 1, wherein said method is applied to an SD card or mini SD card.

6. The method as claimed in claim 1, wherein said method is applied to an MMC card or MMC plus card.

7. The method as claimed in claim 1, wherein said method is applied to an SM card.

8. The method as claimed in claim 1, wherein said method is applied to an MS card.

9. The method as claimed in claim 1, wherein said method is applied to an xD-Picture card.

10. The method as claimed in claim 1, wherein said method is applied to a CF card.
